# EUROPÄISCHE PATENTSCHRIFT

(11) **EP 2 729 838 B1**
(45) Veröffentlichungstag und Bekanntmachung des Hinweises auf die Patenterteilung: **20.11.2019**
(21) Anmeldenummer: 12734910.8
(22) Anmeldetag: 05.07.2012
(51) Int. Cl.: G02B 19/00, F21V 7/00

(54) **OPTISCHES ELEMENT**
OPTICAL ELEMENT
ÉLÉMENT OPTIQUE

(30) Priorität: 08.07.2011 DE 102011078865; 27.10.2011 DE 102011085275
(43) Veröffentlichungstag der Anmeldung: 14.05.2014
(73) Patentinhaber: Zumtobel Lighting GmbH, 6850 Dornbirn (AT)
(72) Erfinder: EBNER, Stephan, 6850 Dornbirn (AT)
(74) Vertreter: Thun, Clemens
(86) Internationale Anmeldenummer: PCT/EP2012/063187
(87) Internationale Veröffentlichungsnummer: WO 2013/007610

(56) Entgegenhaltungen:
- EP-A2- 2 026 109
- WO-A1-2011/027267
- CN-A- 101 324 317
- US-A1- 2006 091 414
- US-A1- 2006 268 556
- US-A1- 2010 038 657
- US-B1- 6 536 923

## Beschreibung

Die vorliegende Erfindung betrifft ein optisches Element gemäß dem Oberbegriff des Anspruchs 1, welches zur Beeinflussung der Lichtabgabe einer im Wesentlichen punktförmigen Lichtquelle, insbesondere einer LED vorgesehen ist. Ferner betrifft die vorliegende Erfindung eine Anordnung zur Beleuchtung, welche eine oder mehrere punktförmige Lichtquelle(n) sowie entsprechend zugeordnete optische Elemente aufweist.

Die fortschreitende Entwicklung von LEDs in den letzten Jahren führt dazu, dass derartige Lichtquellen zunehmend zu Beleuchtungszwecken eingesetzt werden können. Die mit Hilfe von LEDs erzielbaren Lichtstärken sind mittlerweile ausreichend hoch, sodass LEDs in nahezu sämtlichen Anwendungsgebieten bislang verwendete klassische Lichtquellen wie beispielsweise Glühbirnen, Leuchtstofflampen oder Halogenlampen ersetzen können. Ein Vorteil bei der Verwendung von LEDs besteht dabei darin, dass diese sehr gute Möglichkeiten bieten, die Lichtabgabe zu verändern bzw. zu modifizieren. Moderne Lichtquellen auf LED-Basis bieten beispielsweise insbesondere die Möglichkeit, die Farbe oder Farbtemperatur des abgegebenen Lichts einzustellen.

Grundsätzlich strahlen LEDs in einem verhältnismäßig großen Winkelbereich Licht ab. Es ist deshalb üblich, den LEDs optische Elemente, beispielsweise kleine Reflektoren oder Linsen zuzuordnen, über welche die Lichtabgabe auf einen bestimmten Raumbereich beschränkt bzw. konzentriert wird. Hierdurch kann sichergestellt werden, dass das von der Leuchte insgesamt abgegebene Licht bei einem Beobachter keine Blendungen oder störende Reflexionen auf einer reflektierenden Oberfläche, beispielsweise einem Bildschirm oder einer Tischplatte hervorruft.

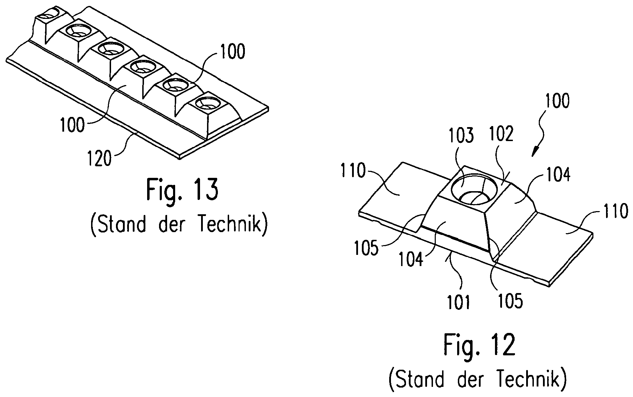

Ein typisches optisches Element, wie es derzeit Verwendung findet, um die Lichtabgabe einer oder mehrerer LEDs zu beeinflussen, ist in den Figuren 12 und 13 dargestellt. Figur 12 zeigt hierbei ein einzelnes optisches Element 100 während hingegen Figur 13 ein längliches Lichtbeeinflussungselement 120 zeigt, welches aus mehreren derartigen, einstückig miteinander verbundenen optischen Elementen besteht. Insbesondere das Lichtbeeinflussungselement 120 gemäß Figur 13 wird beispielsweise verwendet, um die Lichtabgabe einer länglichen Platine, auf der nebeneinander mehrere LEDs angeordnet sind, zu beeinflussen. In diesem Fall ist jeder der einzelnen LEDs ein entsprechendes optisches Element 100 zugeordnet.

Das bekannte optische Element 100 gemäß Figur 12 weist zunächst eine pyramiden- oder kegelstumpfartige Grundform auf, wobei die sich an den pyramiden- bzw. kegelstumpfartigen Körper anschließenden seitlichen Flügel 110 in erster Linie der Halterung des optischen Elements 100 in einer Leuchte dienen. Die Lichtabstrahlfläche dieses Elements 100 wird dementsprechend durch die etwa quadratische Grundfläche 101 des Pyramidenstumpfs gebildet, die Lichteinkopplung findet über die der Grundfläche 101 gegenüberliegende Deckfläche 102 statt. Diese Deckfläche ist mit einer Ausnehmung 103 versehen, wobei im späteren Betriebszustand die - hier nicht dargestellte - LED im Bereich dieser Ausnehmung 103 angeordnet ist. D.h., das von der LED abgegebene Licht tritt über die Bodenfläche sowie die Umfangsfläche der Ausnehmung 103 in das optische Element 100 ein. Ein Teil dieses Lichts trifft dann unmittelbar auf die quadratische Grundfläche 101 und wird über diese abgestrahlt, ein weiterer Teil hingegen wird beim Eintritt in das optische Element 100 derart gebrochen, dass er zunächst gegen die Seitenflächen 104 fällt. Die Form des optischen Elements 100 ist dabei derart gewählt, dass an diesen Seitenflächen 104 eine Totalreflexion der Lichtstrahlen stattfindet, so dass diese wiederum das optische Element 100 über die quadratische Grundfläche 101 verlassen. Die Geometrie sowohl der Ausnehmung 103 als auch der Seitenflächen 104 ist dabei derart gewählt, dass sich eine gewünschte Verteilung für das über die Grundfläche 101 abgestrahlte Licht ergibt.

Bekanntlicherweise ist die Lichtabgabe einer LED annäherungsweise rotationssymmetrisch. Dies bedeutet, dass auch die Verwendung eines rotationssymmetrisch ausgestalteten optischen Elements an sich geeigneter wäre, um das Licht in gewünschter Weise zu beeinflussen. In diesem Fall würde dann allerdings nicht die Möglichkeit bestehen, mehrere derartige optische Elemente einstückig miteinander zu verbinden und hierbei eine geschlossene flächige Lichtabgabe zu erzielen.

Die in Figur 12 dargestellte Form des bekannten optischen Elements wird deshalb in der Regel bevorzugt, da aufgrund der quadratischen Lichtabstrahlfläche die Möglichkeit besteht, mehrere derartiger Elemente 100 - wie in Figur 13 dargestellt - zu einem länglichen Lichtbeeinflussungselement 120 zusammenzufügen, wobei sich dann über die gesamte Länge des Lichtbeeinflussungselement 120 hinweg eine im Wesentlichen homogene Lichtabstrahlung ergibt. Ferner kann durch eine entsprechende Anpassung der Ausnehmung 103 sowie der Seitenflächen 104 die Lichtabstrahlcharakteristik innerhalb gewünschter Bereiche angepasst werden.

Es hat sich nunmehr allerdings gezeigt, dass bei dem optischen Element gemäß Figur 12 bzw. dem Lichtbeeinflussungselement von Figur 13 unter bestimmten Winkelbereichen keine ausreichende Entblendung des abgegebenen Lichts erzielt wird. Grund hierfür ist, dass an den vier Kanten 105 des pyramidenstumpfartigen Körpers Streulicht auftritt, welches im Wesentlichen unkontrolliert das optische Element verlässt. Dies führt zu einer Reduzierung der optischen Effizienz insbesondere in den sogenannten C-Ebenen 45, 135, 225 und 315.

Aus der US 2010/038657 A1 ist eine LED-basierte Beleuchtungsvorrichtung mit verbesserten Lichtabschirmungseigenschaften zur Verringerung der Blendwirkung bekannt. Zu diesem wird ein Reflektor verwendet, der entsprechend der Vielzahl an Lichtemissionseinrichtungen ebenso eine Vielzahl an reflektierenden Oberflächen aufweist. Die reflektierenden Oberflächen der Lichtemissionseinheiten weisen richtungsabhängig unterschiedliche Krümmungsradien auf.

Aus der US 2006/0268556 A1 ist ein optisches Element zur Beeinflussung der Lichtabgabe einer LED bekannt. Das optische Element weist eine in etwa kegelstumpfförmige Fläche zur Lichtbeeinflussung auf.

Aus der EP 2 026 109 A2 ist ein optisches Element zur Beeinflussung der Lichtabgabe einer LED bekannt. Das optische Element ist im Wesentlichen kegelstumpfartig geformt; es weist eine rechteckige Grundfläche zur Lichtabgabe und eine Deckfläche zum Lichteintritt auf. Von der Deckfläche erstrecken sich Bereiche der Mantelfläche in Richtung der Ecken der Grundfläche.

Aus der US 2006/0091414 A1 ist ein optisches Element zur Beeinflussung der Lichtabgabe einer LED bekannt. Das optische Element ist kegelstumpfartig geformt und weist dabei eine rechteckige Grundfläche zur Lichtabgabe auf.

Der vorliegenden Erfindung liegt deshalb die Aufgabenstellung zugrunde, ausgehend von dem bekannten optischen Element dieses derart weiter zu verbessern, dass dessen Effizienz gesteigert werden kann.

Die Aufgabe wird durch ein optisches Element, welches die Merkmale des Anspruchs 1 aufweist, gelöst. Vorteilhafte Weiterbildungen der Erfindung sind Gegenstand der abhängigen Ansprüche.

Das optische Element gemäß der vorliegenden Erfindung dient der Beeinflussung der Lichtabgabe einer im Wesentlichen punktförmigen Lichtquelle, insbesondere einer LED, wobei das Element eine pyramidenstumpfartige Grundform mit einer eine Lichtabstrahlfläche bildenden, etwa rechteckigen Grundfläche sowie einer der Lichtquelle zugewandten und eine Lichteintrittsfläche bildenden Deckfläche aufweist.

Die vorliegende Erfindung ist dadurch gekennzeichnet, dass die Deckfläche des optischen Elements rotationssymmetrisch ist und dass sich von der Deckfläche in Richtung zu den Ecken der Grundfläche hin erstreckende Bereiche der Mantelfläche des optischen Elements durch Flächenbereiche gebildet werden, die derart ausgebildet sind, dass keine scharfen Kanten mehr existieren, die sich von den Ecken der Grundfläche zur Deckfläche hin erstrecken.

Das erfindungsgemäße optische Element weist also eine pyramidenstumpfartige Grundform auf, mit einer etwa rechteckigen, insbesondere quadratischen Grundfläche, welche die Lichtabstrahlfläche des optischen Elements bildet und es gestattet, mehrere derartiger Element aneinanderzufügen. Die Lichteinkopplung findet wiederum an der der Grundfläche gegenüberliegenden Deckfläche des optischen Elements statt. Um nunmehr allerdings die bei dem bekannten optischen Element auftretenden Streulichtanteile zu reduzieren, ist - wie eben ausgeführt - vorgesehen, die Kanten des Pyramidenstumpfs zu beschneiden. Insbesondere werden die Kanten derart beschnitten, dass sich von der Deckfläche in Richtung zu den Ecken der Grundfläche hin erstreckende Flächenbereiche ergeben, deren Profil rotationssymmetrisch ausgebildet sind. Es hat sich gezeigt, dass durch diese Maßnahme aufgrund der nunmehr gebildeten geschlossenen Flächenbereiche und der Vermeidung scharfer Kanten oder Ecken der Streulichtanteil reduziert und die optische Effizienz des optischen Elements deutlich erhöht werden kann.

Durch diese erfindungsgemäße Kombination sog. Linsenelemente mit unterschiedlichen Grundgeometrien und Symmetrien wird letztendlich ein optisches Element erhalten, welches die Beibehaltung der angestrebten bzw. bevorzugten rechteckigen, insbesondere quadratischen Lichtaustrittsfläche erlaubt, gleichzeitig allerdings eine Steigerung der optischen Effizienz, insbesondere in den C-Ebenen 45, 135, 225 und 315 ermöglicht. Die erfindungsgemäße Maßnahme führt zu einer Optimierung der Lichtverteilungskurve, da insbesondere der Anteil an Streulicht verringert und die Lichtlenkung verbessert werden kann, was auch zu einer besseren Entblendung führt. Der letztendlich erzielbare Beleuchtungswirkungsgrad kann hierdurch deutlich gesteigert werden.

Die verbleibenden Bereiche der Mantelfläche des optischen Elements, die nachfolgend auch als Seitenflächen bezeichnet werden, können in unterschiedlicher Weise gestaltet werden. Es bietet sich beispielsweise an, diese durch ebene oder gekrümmte Flächenbereiche zu bilden. Dabei können diese Seitenflächen allerdings zusätzlich auch strukturiert sein, insbesondere mit Facetten und/oder Kalotten versehen werden. Hierdurch kann die letztendlich erhaltene Lichtverteilungskurve jeweils gezielt speziellen Wünschen angepasst werden.

Die Deckfläche des optischen Elements kann rotationssymmetrisch oder polygonal ausgebildet sein. Insbesondere weist sie vorzugsweise wiederum eine Ausnehmung auf, wie dies bereits aus dem Stand der Technik bekannt ist. Die Mantelfläche der Ausnehmung kann hierbei einer Parabel, einer Ellipsenform oder einem sogenannten Spline folgen. Die Bodenfläche der Ausnehmung kann je nach gewünschter Lichtabstrahlcharakteristik eben oder gewölbt ausgebildet sein. Gemäß einer besonderen Ausführungsform kann dabei insbesondere auch vorgesehen sein, dass die Ausnehmung eine Einkerbung aufweist. Diese Einkerbung bildet für das einfallende Licht der LED einen sog. Strahlteiler, so dass die letztendlich erhaltene Lichtverteilungskurve zwei seitliche Flügel aufweist. Eine derartige Lichtabstrahlcharakteristik, die oftmals auch als Batwing-Verteilung bezeichnet wird, ist in bestimmten Anwendungsfällen besonders gewünscht, da sie einerseits eine Blendung unter flachen Blickwinkeln vermeidet und andererseits störende Reflexionen auf einer horizontalen Oberfläche vermieden werden. Letztendlich kann also durch eine entsprechende Anpassung der verschiedenen Bestandteile des optischen Elements die Lichtabstrahlcharakteristik genau an eine gewünschte Verteilung angepasst werden.

Nachfolgend soll die Erfindung anhand der beiliegenden Zeichnung näher erläutert werden. Es zeigen:
- Figur 1: ein erstes Ausführungsbeispiel eines erfindungsgemäßen optischen Elements;
- Figuren 2 bis 4: verschiedene Ausführungsbeispiele weiterer erfindungsgemäßer optischer Elemente;
- Figur 5: eine schematische Darstellung der erfindungsgemäßen Vorgehensweise zum Beschneiden der Kanten des optischen Elements;
- Figur 6: eine Darstellung zur Erläuterung der verschiedenen Komponenten bzw. Linsenelemente des erfindungsgemäßen optischen Elements;
- Figuren 7 und 8: mögliche Weiterbildungen der erfindungsgemäßen optischen Elemente;
- Figur 9: die Ausgestaltung einer besonders bevorzugten Eintrittsfläche für das erfindungsgemäße optische Element;
- Figur 10 und 11: Varianten von Lichtbeeinflussungselementen, welche aus mehreren zusammengefügten erfindungsgemäßen optischen Elementen bestehen; und
- Figuren 12 und 13: ein optisches Element sowie ein Lichtbeeinflussungselement gemäß dem Stand der Technik.

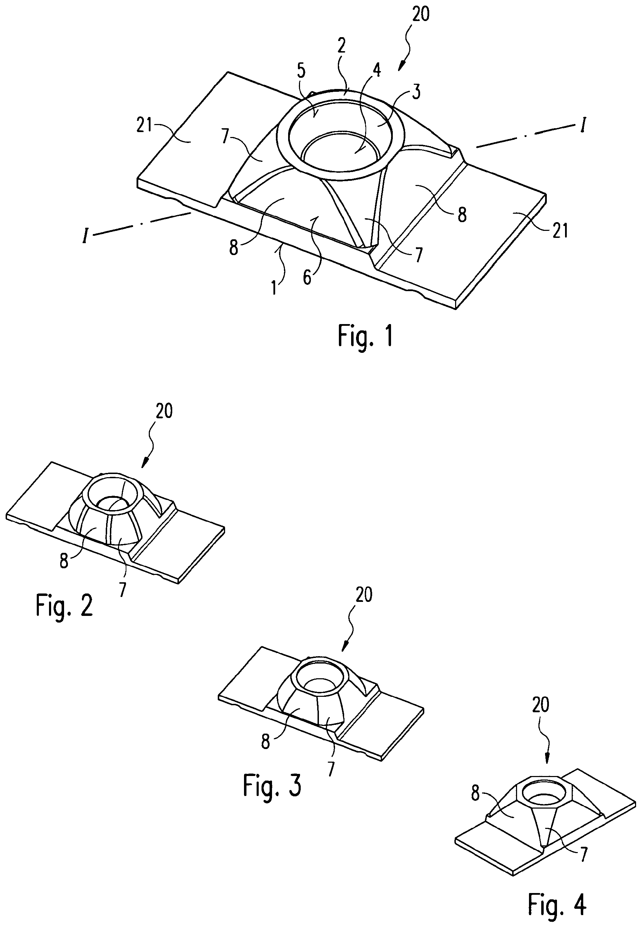

Anhand von Figur 1 soll zunächst die erfindungsgemäße Vorgehensweise zum Erstellen eines optischen Elements erläutert werden. Weitere Varianten werden dann anhand der folgenden Figuren erläutert.

Das allgemein mit dem Bezugszeichen 20 versehene erfindungsgemäße optische Element ist wiederum aus einem transparenten Material, vorzugsweise Kunststoff, kegelstumpf- bzw. pyramidenstumpfartig ausgebildet. Zu beiden Seiten des optischen Elements 20 schließen sich transparente Flügel 21 an, welche in erster Linie der Montage des Elements 20 an einer Leuchte oder einem Leuchtenkörper dienen. Der Einfluss dieser seitlichen Flügel 21 auf die Lichtabgabe ist allerdings vernachlässigbar, auch wenn ein geringfügiger Anteil des Lichts in diese Flügel 21 eingekoppelt wird, so dass diese leicht illuminiert erscheinen.

Die eigentliche Lichtabstrahlung des erfindungsgemäßen optischen Elements 20 findet allerdings wiederum über die Grundfläche 1, also die Unterseite des Kegelstumpfs bzw. Pyramidenstumpfs statt, wobei die ebene Grundfläche 1 rechteckig, vorzugsweise quadratisch ausgebildet ist. Wie bereits eingangs erläutert wurde, führt diese ebene rechteckige Ausgestaltung der Grundfläche 1 dazu, dass das Aneinanderreihen mehrerer gleichartiger optischer Elemente 20 ermöglicht wird, wobei dann über die gesamte Fläche hinweg eine homogene bzw. gleichmäßige Lichtabgabe erhalten wird.

Die der Grundfläche 1 gegenüberliegende Deckfläche 2 des optischen Elements 20 ist der Lichtquelle zugewandt und bildet dementsprechend den Lichteintrittsbereich des optischen Elements 20. Wiederum ist vorgesehen, dass diese Deckfläche 2 mit einer Ausnehmung 3 versehen ist, welche den eigentlichen Lichteintrittsbereich des optischen Elements 20 bildet. Von der Lichtquelle abgegebene Lichtstrahlen treten also einerseits über die Bodenfläche 4 sowie andererseits über die Umfangsfläche 5 der Ausnehmung 3 in das optische Element 20 ein. Ein Teil der Lichtstrahlen tritt dann unmittelbar über die Grundfläche 1 aus dem optischen Element 20 aus, während hingegen ein anderer Teil an der Mantelfläche 6 des optischen Elements 20 totalreflektiert wird, so dass er anschließend über die Grundfläche 1 abgestrahlt werden kann. Die Mantelfläche 6 bildet hierbei eine geschlossene Aussenfläche des Kegelstumpfs, d.h., sie erstreckt sich in kontinuierlicher bzw. monotoner Weise, insbesondere ohne Abstufungen, welche eine sägezahnartige Struktur bilden würden, von dem Lichteintrittsbereich zur Grundfläche. Insoweit entspricht der Aufbau des erfindungsgemäßen optischen Elements 20 dem des bekannten optischen Elements 100 aus Figur 12.

Eine Besonderheit des erfindungsgemäßen optischen Elements 20 besteht nunmehr allerdings in der Ausgestaltung der Mantelfläche 6. Diese ist nunmehr derart gestaltet, dass keine scharfen Kanten mehr existieren, die sich von den Ecken der Grundfläche 1 zur Deckfläche 2 hin erstrecken. Stattdessen wurden diese Kanten in spezieller Weise beschnitten, sodass sich nunmehr neuartige Flächenbereiche 7 ergeben, die sich als geschlossene Flächen von den Ecken der Grundfläche 1 zur Deckfläche 2 hin erstrecken. Beim dargestellten Ausführungsbeispiel sind diese Flächenbereiche 7, die nachfolgend auch als Eckflächen bezeichnet werden, derart ausgestaltet, dass sie in Bezug auf eine durch das Zentrum des optischen Elements 20 verlaufende Achse eine Rotationssymmetrie aufweisen.

Die bislang auftretenden Kanten wurden also nunmehr in Umfangsrichtung gesehen abgerundet, was letztendlich dazu führt, dass in diesen Bereichen das bislang durch die scharfen Kanten hervorgerufene Streulicht stark unterdrückt wird. Stattdessen kann auch in diesen Bereichen nunmehr die angestrebte Totalreflexion der auftreffenden Lichtstrahlen erzielt werden, sodass letztendlich die Effizienz des erfindungsgemäßen optischen Elements 20 insgesamt gesehen deutlich verbessert wird.

Die verbleibenden Flächenbereiche, also die sich von den vier Kanten der Grundfläche 1 zur Deckfläche 2 hin erstreckenden Seitenflächen 8 des optischen Elements 20 sind zunächst unverändert, sie erfüllen also ihre lichttechnische Aufgabe, nämlich auftretende Lichtstrahlen zu reflektieren, in der bislang gewohnten Weise.

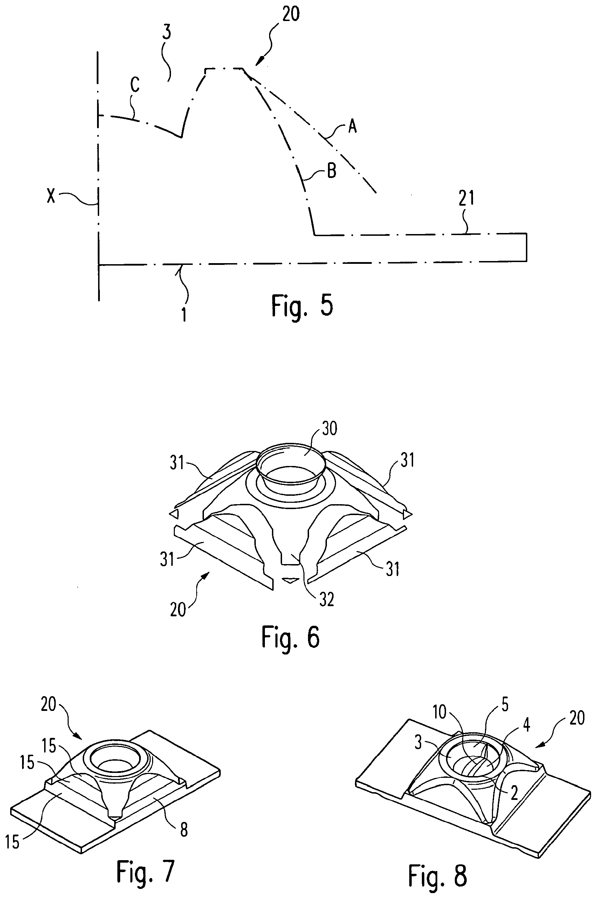

Die erfindungsgemäße Vorgehensweise wird schematisch nochmals anhand der Darstellung von Figur 5 verdeutlicht, welche eine teilweise Schnittdarstellung des optischen Elements 20 entlang der Achse I-I von Figur 1 zeigt, d.h., die Darstellung verläuft durch einen Eckbereich des optischen Elements 20. Die Kurve A entspricht hierbei dem Verlauf des Kantenbereichs, wie er bei dem optischen Element 100 aus dem Stand der Technik gemäß der Figur 12 vorliegt. Erfindungsgemäß wird dieser Kantenbereich nunmehr derart beschnitten, dass sich ein Verlauf entsprechend der Kurve B ergibt. Die zuvor scharfe Kante des Pyramidenstumpfs wird nunmehr also durch eine Fläche ersetzt, wobei dieser - kontinuierlich bzw. monoton zur Grundfläche hin abfallender - Flächenbereich bei dem Ausführungsbeispiel gemäß Figur 1 eine Rotationssymmetrie in Bezug auf die Zentralachse X aufweist. Wie später noch näher erläutert wird, kann der sich durch die Beschneidung der Kante ergebende Flächenbereich allerdings auch translatorisch bzw. eben ausgebildet sein. Die Kurve C zeigt den Verlauf der Bodenfläche und Umfangsfläche der Ausnehmung 3, welche in der bislang bekannten Weise ausgestaltet bzw. je nach gewünschter Abstrahlcharakteristik angepasst ist.

Kerngedanke der Erfindung ist also, eine gezielte Aneinanderreihung unterschiedlicher Linsenelemente mit verschiedenen Grundgeometrien, insbesondere Splines, Parabeln, Ellipsen usw. und Symmetrien vorzunehmen. Figur 6 verdeutlicht hierbei, was unter Linsenelementen verstanden wird, wobei wiederum ein erfindungsgemäßes optisches Element 20 - nunmehr in Explosionsdarstellung - dargestellt ist. Ein erstes Linsenelement ist hierbei die sogenannte Eintrittslinse 30, welche durch die Ausnehmung 3 in der Deckfläche des pyramidenstumpfartigen Körpers gebildet wird. Diese Eintrittslinse 30 weist vorzugsweise eine der Lichtabstrahlcharakteristik einer LED entsprechende Rotationssymmetrie auf. Bei den vier Seitenflächen, also denjenigen Bereichen, die sich von den vier Kanten der Grundfläche des Pyramidenstumpfs in Richtung der Deckfläche erstrecken, handelt es sich vorzugsweise um lineare bzw. translatorische Linsenelemente 31. Wie später noch näher erläutert wird, können insbesondere diese linearen bzw. translatorischen Linsenelemente noch speziell strukturiert werden, um die Lichtabgabe weiter zu optimieren. Durch die bereits erläuterte erfindungsgemäße Beschneidung der Kantenbereiche ergeben sich ferner rotationssymmetrische Linsenelemente 32, durch welche insbesondere das Auftreten der ungewünschten Streustrahlung unterdrückt wird. Dadurch, dass diese verschiedenen Linsenelemente gezielt hinsichtlich ihrer Form beeinflusst und dann miteinander kombiniert werden, kann die letztendlich erhaltene Lichtverteilungskurve individuell an spezielle Wünsche angepasst werden. Die einzelnen Linsenelemente des optischen Elements 20 tragen hierbei zu unterschiedlich starken Anteilen zu der Gesamtabstrahlcharakteristik bei und können somit unterschiedliche Bereiche beleuchten. Dabei kann auch zwischen den einzelnen Linsenelementen durch einen gezielten Verlauf des Übergangs von einem Element in das andere die Effizienz erhöht und die Reduzierung der Streulichtanteile weiter verbessert werden. Werden die einzelnen Linsenelemente auf ihre Grundlinien reduziert und dann die entsprechenden Linien gezielt mit einem gesteuerten Verlauf verbunden, so lassen sich optimierte Freiformflächen erzeugen, was letztendlich zu einer individuellen Gestaltung der Lichtverteilungskurve führt.

Nachfolgend sollen weitere denkbare Ausgestaltungen eines erfindungsgemäßen optischen Elements erläutert werden. Allen Ausführungsbeispielen ist allerdings gemeinsam, dass insbesondere die Kantenbereiche beschnitten wurden.

Bei der Variante gemäß Figur 2 erfolgte wiederum die Beschneidung derart, dass die sich ergebenden Eckflächenbereiche 7 rotationssymmetrisch ausgebildet sind. Die Beschneidung ist nunmehr allerdings im unteren, der Grundfläche 1 zugewandten Bereich großflächiger ausgeführt, sodass diese Eckflächen 7 nunmehr durch eine untere gekrümmte Linie begrenzt sind. Die Seitenflächen 8 sind unverändert ausgebildet und können eben sein oder einer leicht gekrümmten Kurve folgen.

Bei dem Ausführungsbeispiel von Figur 3 erfolgt die Beschneidung der Kanten derart, dass die Eckflächen 7 nunmehr eben bzw. translatorisch ausgebildet sind. Hier - analog zu Figur 2 - ist der untere Bereich einer Eckfläche 7 breit ausgeführt.

Figur 4 wiederum entspricht hinsichtlich der Ausgestaltung der Eckflächen 7 im Wesentlichen dem ersten Ausführungsbeispiel von Figur 1, d.h., die Eckflächen 7 laufen wiederum spitz auf die Eckbereiche der Grundfläche 1 zu. Allerdings erfolgte auch hier nunmehr eine translatorische Kantenbeschneidung, d.h., die Eckflächen 7 sind eben ausgebildet.

Die soeben erläuterten Ausführungsbeispiele verdeutlichen, dass das erfindungsgemäße optische Element vielfältig ausgestaltet sein kann. So kann beispielsweise auch die Ausnehmung 3 der Deckfläche 2 bzw. die Deckfläche 2 selbst rotationssymmetrisch oder polygonal ausgeführt sein. In jedem Fall werden allerdings die ursprünglich scharfen Kanten des Pyramidenstumpfs durch Flächen ersetzt, was aufgrund der sich hieraus ergebenden Reduzierung des Streulichts zu einer deutlichen Verbesserung der lichttechnischen Eigenschaften führt.

Eine denkbare Weiterbildung, die bei jedem der zuvor beschriebenen Ausführungsbeispiele der Figuren 1 bis 4 zum Einsatz kommen könnte, ist in Figur 7 dargestellt. Hierbei sind insbesondere die Seitenflächen 8 strukturiert ausgebildet, also mit Facetten 15 versehen. Durch diese zusätzlichen Strukturelemente kann die Lichtverteilungskurve des optischen Elements 20 zusätzlich in gewünschter Weise beeinflusst werden, wobei selbstverständlich auch alternativ oder ergänzend eine Facettierung der Eckflächen 7 denkbar wäre. Auch könnten auch andere Strukturierungen, beispielsweise Kalotten oder dergleichen zum Einsatz kommen.

Eine alternative oder ergänzende Weiterbildung ist auch in Figur 8 dargestellt, wobei in diesem Fall die Ausnehmung 3 der Deckfläche 2 mit einer Einkerbung 10 versehen ist. Die Einkerbung 10 erstreckt sich sowohl über die Bodenfläche 4 als auch die Umfangsfläche 5 der Ausnehmung 2 und bewirkt eine Teilung des von der Lichtquelle in das optische Element 20 einfallenden Lichts. Somit wird hierdurch ein Strahlteiler gebildet, über den das von dem optischen Element 20 abgegebene Licht in zwei Bündel aufgeteilt wird, welche im Wesentlichen symmetrisch zu einer durch die Einkerbung definierten Ebene ausgerichtet sind. Diese zwei Strahlenbündel sind in einem Winkel gegenüber der Vertikalen ausgerichtet, so dass sich eine sogenannte Batwing-Verteilung ergibt. Eine derartige Lichtabstrahlcharakteristik verhindert zum einen das Auftreten von Blendungen, wenn die Leuchte unter flachen Winkeln betrachtet wird. Zum anderen werden auf horizontalen Flächen unterhalb der Leuchte störende Reflexionen vermieden, so dass sich eine derartige Lichtabstrahlcharakteristik beispielsweise an Arbeitsplätzen aber auch auf anderen Gebieten sehr gut eignet. Das Einsetzen eines derartigen Strahlteiles in Form der Einkerbung 10 ist wiederum bei allen zuvor beschriebenen Ausführungsbeispielen denkbar.

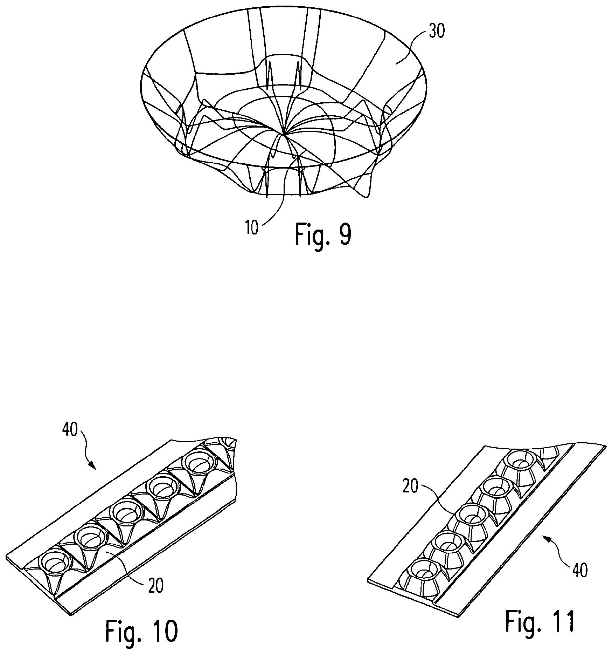

Eine optimierte Gestaltung für die Eintrittslinse 30, welche eine derartige Einkerbung 10, also einen Strahlteiler beinhaltet, ist nochmals näher in Figur 9 dargestellt. Diese Darstellung zeigt deutlich, dass durch eine entsprechende Gestaltung der einzelnen Linsenelemente des erfindungsgemäßen optischen Elements die Anpassung der Lichtverteilungskurve optimiert und damit die Effizienz verbessert werden kann.

Wie bereits erwähnt besteht ein besonderer Vorteil der erfindungsgemäßen Lösung darin, dass bei dem optischen Element 20 trotz einer rechteckigen, insbesondere einer quadratischen Lichtaustrittsfläche eine gleichmäßige Lichtabgabe erzielt werden kann, obwohl die als Lichtquelle zum Einsatz kommende LED eher eine rotationssymmetrische Lichtabstrahlcharakteristik aufweist. Diese Eigenschaft führt dazu, dass sich die erfindungsgemäßen optischen Elemente in besonders guter Weise dazu eignen, zu größeren Lichtbeeinflussungselementen zusammengefügt zu werden. Figuren 10 und 11 zeigen hierbei zwei Beispiele eines Lichtbeeinflussungselements 40, welche jeweils aus mehreren, einstückig miteinander verbundenen optischen Elementen 20 bestehen, wobei bei dem Lichtbeeinflussungselement 40 gemäß Figur 10 optische Elemente wie in Figur 1 zum Einsatz kommen. Das Lichtbeeinflussungselement 40 gemäß Figur 11 beruht auf optischen Elementen 20 der Variante gemäß Figur 2. Bei beiden Ausführungsbeispielen wird über die gesamte Fläche des Lichtbeeinflussungselements 40 hinweg eine gleichmäßige Lichtabgabe mit der angestrebten Lichtabstrahlcharakteristik erzielt, obwohl die Lichterzeugung durch punktförmige Lichtquellen erfolgt. Dieser an sich bestehende Widerspruch wird durch die erfindungsgemäße Lösung besonders elegant und in effektiver Weise gelöst.

## Patentansprüche

1. Optisches Element (20) zur Beeinflussung der Lichtabgabe einer im Wesentlichen punktförmigen Lichtquelle, insbesondere einer LED,
wobei das Element (20) eine pyramidenstumpfartige Grundform mit einer eine Lichtabstrahlfläche bildenden, etwa rechteckigen Grundfläche (1) sowie einer der Lichtquelle zugewandten und eine Lichteintrittsfläche bildenden Deckfläche (2) aufweist,
**dadurch gekennzeichnet,**
**dass** die Deckfläche (2) des optischen Elements (20) rotationssymmetrisch ist und dass sich von der Deckfläche (2) in Richtung zu den Ecken der Grundfläche (1) hin erstreckende Bereiche der Mantelfläche (6) des optischen Elements (20) durch Flächenbereiche (7) gebildet werden, die derart ausgebildet sind, dass keine scharfen Kanten mehr existieren, die sich von den Ecken der Grundfläche (1) zur Deckfläche (2) hin erstrecken.

2. Optisches Element nach Anspruch 1,
**dadurch gekennzeichnet,**
**dass** die verbleibenden Bereiche der Mantelfläche (6) des optischen Elements (20) durch ebene Flächenbereiche gebildet werden.

3. Optisches Element nach Anspruch 1 oder 2,
**dadurch gekennzeichnet,**
**dass** Bereiche der Mantelfläche (6) des optischen Elements (20) strukturiert, insbesondere mit Facetten (15) oder Kalotten versehen sind.

4. Optisches Element nach einem der vorherigen Ansprüche,
**dadurch gekennzeichnet,**
**dass** die Deckfläche (2) des optischen Elements (20) eine Ausnehmung (3) aufweist.

5. Optisches Element nach Anspruch 4,
**dadurch gekennzeichnet,**
**dass** die Umfangsfläche (5) der Ausnehmung (3) einer Parabel, einer Ellipsenform oder einem Spline folgt.

6. Optisches Element nach Anspruch 4 oder 5,
**dadurch gekennzeichnet,**
**dass** die Bodenfläche (4) der Ausnehmung (3) gewölbt ist.

7. Optisches Element nach einem der Ansprüche 4 bis 6,
**dadurch gekennzeichnet,**
**dass** die Ausnehmung (3) eine Einkerbung (10) aufweist.

8. Optische Element nach einem der vorherigen Ansprüche,
**dadurch gekennzeichnet,**
**dass** die Grundfläche (1) des optischen Elements (20) quadratisch ist.

9. Lichtbeeinflussungselement (40) zum Beeinflussen des Lichts mehrerer punktförmiger Lichtquellen, insbesondere LEDs, wobei das Lichtbeeinflussungselement (40) aus mehreren einstückig miteinander verbundenen optischen Elementen (20) gemäß einem der vorherigen Ansprüche besteht.

## Claims

1. An optical element (20) for influencing the light emission of a substantially punctiform light source, in particular an LED, wherein the element (20) has a truncated pyramid-like basic shape with an approximately rectangular base (1) that forms a light-emitting surface and a cover surface (2) which faces the light source and which forms a light inlet surface,
**characterized in**
**that** the cover surface (2) of the optical element (20) is rotationally symmetrical and that the regions of the lateral face (6) of the optical element (20) extending from the cover surface (2) in the direction towards the corners of the base (1) are formed by surface regions (7), which are designed in such a manner that no sharp edges exist anymore, which extend from the corners of the base (1) to the cover surface (2).

2. The optical element according to Claim 1,
**characterized in**
**that** the remaining regions of the lateral face (6) of the optical element (20) are formed by flat surface regions.

3. The optical element according to Claim 1 or 2,
**characterized in**
**that** regions of the lateral face (6) of the optical element (20) are structured, in particular, are provided with facets (15) or calottes.

4. The optical element according to any one of the preceding claims, **characterized in**
**that** the cover surface (2) of the optical element (20) has a recess (3).

5. The optical element according to Claim 4,
**characterized in**
**that** the circumferential surface (5) of the recess (3) follows a parabola, an elliptical shape or a spline.

6. The optical element according to Claim 4 or 5,
**characterized in**
**that** the bottom surface (4) of the recess (3) is curved.

7. The optical element according to any one of Claims 4 to 6,
**characterized in**
**that** the recess (3) has a notch (10).

8. The optical element according to any one of the preceding claims, **characterized in**
**that** the base (1) of the optical element (20) is square.

9. The light-influencing element (40) for influencing the light of a plurality of punctiform light sources, in particular LEDs, wherein the light-influencing element (40) consists of a plurality of optical elements (20) connected integrally with one another according to any one of the preceding claims.

## Revendications

1. Elément optique (20) destiné à influencer l'émission de lumière d'une source de lumière essentiellement ponctuelle, en particulier d'une LED,
dans lequel l'élément (20) présente une forme de base en forme de pyramide tronquée avec une surface de base (1) à peu près rectangulaire formant une surface de rayonnement de lumière, ainsi qu'avec une surface supérieure (2) tournée vers la source de lumière et formant une surface d'entrée de lumière, **caractérisé en ce que**
la surface supérieure (2) de l'élément optique (20) est symétrique en rotation et **en ce que** des zones de la surface d'enveloppe (6) de l'élément optique (20) qui s'étendent à partir de la surface supérieure (2) en direction des coins de la surface de base (1) sont formées par des zones de surface (7) qui sont constituées de telle sorte qu'il n'existe plus d'arêtes vives qui s'étendent à partir des coins de la surface de base (1) vers la surface supérieure (2).

2. Elément optique selon la revendication 1,
**caractérisé en ce que** les zones restantes de la surface d'enveloppe (6) de l'élément optique (20) sont formées par des zones de surface planes.

3. Elément optique selon la revendication 1 ou 2, **caractérisé en ce que**
des zones de la surface d'enveloppe (6) de l'élément optique (20) sont structurées, en particulier sont munies de facettes (15) ou de calottes.

4. Elément optique selon l'une des revendications précédentes,
**caractérisé en ce que**
la surface supérieure (2) de l'élément optique (20) comporte un évidement (3).

5. Elément optique selon la revendication 4,
**caractérisé en ce que**
la surface périphérique (5) de l'évidement (3) suit une parabole, une forme d'ellipse ou une spline.

6. Elément optique selon la revendication 4 ou 5,
**caractérisé en ce que**
la surface de fond (4) de l'évidement (3) est bombée.

7. Elément optique selon l'une des revendications 4 à 6, **caractérisé en ce que**
l'évidement (3) comporte une encoche (10).

8. Elément optique selon l'une des revendications précédentes,
**caractérisé en ce que**
la surface de base (1) de l'élément optique (20) est carrée.

9. Elément influençant la lumière (40) destiné à influencer la lumière de plusieurs sources de lumière ponctuelles, en particulier de LED, dans lequel l'élément influençant la lumière (40) se compose de plusieurs éléments optiques (20) raccordés entre eux d'une seule pièce selon l'une des revendications précédentes.
